# EUROPÄISCHE PATENTSCHRIFT

(11) **EP 3 738 409 B1**
(45) Veröffentlichungstag und Bekanntmachung des Hinweises auf die Patenterteilung: **10.01.2024**
(21) Anmeldenummer: 18815815.8
(22) Anmeldetag: 26.11.2018
(51) Int. Cl.: H05B 6/12, F24C 7/08, F24C 15/10

(54) **KOCHFELD**
COOKING HOB
PLAQUE DE CUISSON

(30) Priorität: 08.01.2018 ES 201830012
(43) Veröffentlichungstag der Anmeldung: 18.11.2020
(73) Patentinhaber: BSH Hausgeräte GmbH, 81739 München (DE)
(72) Erfinder: ABADIA GALLEGO, David Ignacio, 50002 Zaragoza (ES); AZUARA GAZO, Jesus Enrique, 50021 Zaragoza (ES); LAPETRA CAMPOS, Isaac, 50003 Zaragoza (ES); MIR BEL, Jorge, 50019 Zaragoza (ES); ONDIVIELA SERRANO, Esther, 50019 Zaragoza (ES); PALACIOS TOMAS, Daniel, 50008 Zaragoza (ES)
(86) Internationale Anmeldenummer: PCT/IB2018/059299
(87) Internationale Veröffentlichungsnummer: WO 2019/135116

(56) Entgegenhaltungen:
- EP-A1- 2 112 861
- WO-A1-96/31739
- WO-A1-2016/147060
- WO-A1-2017/013558
- WO-A1-2017/068716
- WO-A1-2017/143146
- CN-A- 1 812 673
- DE-A1-102004 033 449
- DE-A1-102005 005 527
- DE-A1-102017 208 033
- GB-A- 2 100 853
- JP-A- H03 127 484
- JP-A- 2009 163 898
- JP-A- 2009 224 166
- JP-A- 2011 243 320
- JP-A- 2011 253 805
- JP-A- 2017 208 218
- US-A1- 2012 060 030

## Beschreibung

Die Erfindung betrifft ein Haushaltsgerät mit einer Haushaltsgerätevorrichtung nach dem Oberbegriff des Anspruchs 1.

Aus dem Stand der Technik ist bereits eine Haushaltsgerätevorrichtung bekannt, welche eine Funkempfangseinheit aufweist. Die Funkempfangseinheit weist eine Empfangsleiterplatte, welche zu einem Empfang eines Funksignals vorgesehen ist, und eine Verarbeitungsleiterplatte, welche getrennt von der Empfangsleiterplatte ausgebildet ist, auf. Eine Lagereinheit lagert die Empfangsleiterplatte und die Verarbeitungsleiterplatte in einem Betriebszustand bezüglich einer Vertikalrichtung, welche senkrecht zu einer Haushaltsgeräteplatte und zu einer Haupterstreckungsebene der Verarbeitungsleiterplatte ausgerichtet ist, beabstandet zueinander. Bei einer Betrachtung in einer senkrecht zu einer Haupterstreckungsebene der Verarbeitungsleiterplatte ausgerichteten Richtung lagert die Lagereinheit in dem Betriebszustand die Empfangsleiterplatte und die Verarbeitungsleiterplatte überlappend zueinander. Ferner ist aus der Druckschrift WO 2017/013558 A1 ein Kochfeld mit einer Gehäuseeinheit bekannt, wobei eine Elektronikeinheit außerhalb des Kochfelds und eine weitere Elektronikeinheit innerhalb des Kochfelds, und zwar in der Gehäuseeinheit angeordnet sind. Die Elektronikeinheit und die weitere Elektronikeinheit sind mittels einer Verdrahtung in einem montierten Zustand miteinander verbunden.

Zudem offenbart die Druckschrift US 2012/060030 A1 einen Desktopcomputer mit einem Mainboard, welches unter anderem einen PCI Slot aufweist. Der Oberbegriff des Anspruchs 1 ist aus der WO 2017/068716 A1 bekannt.

Die Aufgabe der Erfindung besteht insbesondere darin, eine gattungsgemäße Vorrichtung mit verbesserten Eigenschaften hinsichtlich eines Funkempfangs bereitzustellen. Die Aufgabe wird erfindungsgemäß durch die Merkmale des Anspruchs 1 gelöst, während vorteilhafte Ausgestaltungen und Weiterbildungen der Erfindung den Unteransprüchen entnommen werden können.

Die Erfindung geht aus von einem Haushaltsgerät mit einer Haushaltsgerätevorrichtung, beispielsweise von einer Gargerätevorrichtung, insbesondere von einer Kochfeldvorrichtung und vorteilhaft von einer Induktionskochfeldvorrichtung, mit zumindest einer Funkempfangseinheit, welche zumindest eine Empfangsleiterplatte, die zu einem Empfang zumindest eines Funksignals vorgesehen ist, und zumindest eine Verarbeitungsleiterplatte, die zu einer Verarbeitung des empfangenen Funksignals vorgesehen ist, aufweist, und mit zumindest einer Lagereinheit, welche die Empfangsleiterplatte beabstandet zu der Verarbeitungsleiterplatte lagert.

Es wird vorgeschlagen, dass die Lagereinheit bei einer Betrachtung in einer senkrecht zu einer Haupterstreckungsebene der Verarbeitungsleiterplatte ausgerichteten Richtung die Empfangsleiterplatte und die Verarbeitungsleiterplatte überlappungsfrei lagert.

Durch die erfindungsgemäße Ausgestaltung kann insbesondere ein optimierter Funkempfang erreicht werden. Insbesondere können die Empfangsleiterplatte und die Verarbeitungsleiterplatte flexibel relativ zueinander angeordnet werden, wodurch insbesondere eine hohe Flexibilität und/oder Gestaltungsfreiheit hinsichtlich einer Anordnung der Empfangsleiterplatte und der Verarbeitungsleiterplatte erreicht werden kann. Es können insbesondere akzeptable Temperaturen der Verarbeitungsleiterplatte und/oder der Empfangsleiterplatte ermöglicht werden, und zwar insbesondere durch Lagerung der Verarbeitungsleiterplatte und/oder der Empfangsleiterplatte in entsprechend geeigneten Temperaturbereichen, insbesondere innerhalb der Gehäuseeinheit. Es kann insbesondere ein optimierter Funkempfang gewährleistet werden.

Unter einer "Haushaltsgerätevorrichtung", insbesondere unter einer "Gargerätevorrichtung", vorteilhaft unter einer "Kochfeldvorrichtung" und besonders vorteilhaft unter einer "induktionskochfeldvorrichtung" soll insbesondere zumindest ein Teil, insbesondere eine Unterbaugruppe, eines Haushaltsgeräts, insbesondere eines Gargeräts, vorteilhaft Kochfelds und besonders vorteilhaft eines Induktionskochfelds, verstanden werden. Beispielsweise könnte es sich bei einem die Haushaltsgerätevorrichtung aufweisenden Haushaltsgerät um eine Kühltruhe und vorteilhaft um einen Kühl- und/oder Gefrierschrank handeln. Ein die Haushaltsgerätevorrichtung aufweisendes Haushaltsgerät könnte alternativ oder zusätzlich beispielsweise eine Spülmaschine und/oder eine Waschmaschine und/oder ein Trockner sein. Vorteilhaft handelt es sich bei einem die Haushaltsgerätevorrichtung aufweisenden Haushaltsgerät um ein Gargerät. Ein als Gargerät ausgebildetes Haushaltsgerät könnte beispielsweise ein Backofen und/oder eine Mikrowelle und/oder ein Grillgerät und/oder ein Dampfgargerät sein. Vorteilhaft ist ein als Gargerät ausgebildetes Haushaltsgerät ein Kochfeld und vorzugsweise ein Induktionskochfeld.

Unter einer "Funkempfangseinheit" soll insbesondere eine Einheit verstanden werden, welche in wenigstens einem Betriebszustand zumindest ein Funksignal von zumindest einer Funksendungseinheit empfängt und welche das empfangene Funksignal insbesondere weiter verarbeitet und/oder an zumindest eine weitere Einheit, insbesondere der Haushaltsgerätevorrichtung, insbesondere zum Zweck einer weiteren Verarbeitung des Funksignals, weiterleitet. Unter einer "Funksendungseinheit" soll insbesondere eine Einheit verstanden werden, welche in wenigstens einem Betriebszustand zumindest ein Funksignal aussendet, und zwar insbesondere an zumindest eine Funkempfangseinheit. Die Funksendungseinheit könnte beispielsweise in zumindest einer Radio-Sende-Station und/oder in zumindest einer Telekommunikations-Funk-Sende-Station wenigstens teilweise integriert sein. Alternativ oder zusätzlich könnte die Funksendungseinheit beispielsweise in zumindest einem weiteren Haushaltsgerät wenigstens teilweise integriert sein.

Die Funkempfangseinheit könnte beispielsweise zusätzlich zu einem Empfang zumindest eines Funksignals zu einem Versenden zumindest eines Funksignals vorgesehen sein. Insbesondere könnte die Funkempfangseinheit wenigstens teilweise einstückig mit zumindest einer Funksendungseinheit der Haushaltsgerätevorrichtung ausgebildet sein.

Unter einem "Funksignal" soll insbesondere zumindest ein durch Funkwellen ausgesendetes Zeichen verstanden werden. Unter "Funkwellen" soll insbesondere elektrische und/oder magnetische Strahlung, insbesondere elektromagnetische Strahlung, verstanden werden, deren Frequenz maximal 5000 GHz, insbesondere maximal 4000 GHz, vorteilhaft maximal 3500 GHz und vorzugsweise maximal 3000 GHz beträgt und welche sich unter Vermeidung einer künstlichen Führung im freien Raum ausbreitet.

Unter einer "Empfangsleiterplatte" soll insbesondere eine Leiterplatte verstanden werden, welche zumindest einen Funkempfänger und/oder zumindest eine Antenne zu einem Empfang zumindest eines Funksignals aufweist. Die Empfangsleiterplatte weist insbesondere zumindest eine Kommunikationseinheit auf, welche zu einer Kommunikation mit der Verarbeitungsleiterplatte und/oder zu einer Übermittlung des empfangenen Funksignals an die Verarbeitungsleiterplatte vorgesehen ist.

Unter einer "Verarbeitungsleiterplatte" soll insbesondere eine Leiterplatte verstanden werden, welche in wenigstens einem Betriebszustand insbesondere zumindest ein von der Empfangsleiterplatte empfangenes Funksignal von der Empfangsleiterplatte erhält und das erhaltene Funksignal insbesondere weiter verarbeitet und/oder an zumindest eine weitere Einheit weiterleitet. Die Verarbeitungsleiterplatte weist insbesondere zumindest eine Kommunikationseinheit auf, welche zu einer Kommunikation mit der Empfangsleiterplatte und/oder zu einem Empfang des von der Empfangsleiterplatte empfangenen Funksignals vorgesehen ist.

In wenigstens einem Betriebszustand könnten die Empfangsleiterplatte und die Verarbeitungsleiterplatte insbesondere mechanisch, beispielsweise mittels zumindest eines Kabels, und/oder elektrisch und/oder elektronisch miteinander verbunden sein und insbesondere über das Kabel miteinander kommunizieren. Insbesondere könnte die Funkempfangseinheit zumindest ein Kabel aufweisen, mittels welchem die Empfangsleiterplatte und die Verarbeitungsleiterplatte in wenigstens einem Betriebszustand insbesondere miteinander kommunizieren könnten. Alternativ oder zusätzlich könnten die Empfangsleiterplatte und die Verarbeitungsleiterplatte in wenigstens einem Betriebszustand insbesondere drahtlos miteinander kommunizieren.

Unter einer "Leiterplatte" soll insbesondere eine Einheit verstanden werden, welche in wenigstens einem Betriebszustand zumindest eine elektrische und/oder elektronische Baueinheit trägt und welche insbesondere zu einer mechanischen Befestigung und/oder zu einer elektrischen Kontaktierung zumindest einer elektrischen und/oder elektronischen Baueinheit vorgesehen ist. Insbesondere besteht die Leiterplatte wenigstens zu einem Großteil aus elektrisch isolierendem Material. Die Leiterplatte weist insbesondere zumindest eine Leiterbahn und zumindest einen Grundkörper auf, auf welchem die Leiterbahn wenigstens zu einem Großteil angeordnet ist. Unter "wenigstens zu einem Großteil" soll insbesondere zu einem Anteil, insbesondere einem Massenanteil und/oder Volumenanteil, von mindestens 70 %, insbesondere von mindestens 80 %, vorteilhaft von mindestens 90 % und vorzugsweise von mindestens 95 % verstanden werden.

Unter einer "Lagereinheit" soll insbesondere eine Einheit verstanden werden, welche in wenigstens einem Betriebszustand zumindest eine Gewichtskraft der Funkempfangseinheit, insbesondere der Empfangsleiterplatte und/oder der Verarbeitungsleiterplatte, wenigstens teilweise aufnimmt und/oder an zumindest ein weiteres Objekt überträgt. Insbesondere weist die Haushaltsgerätevorrichtung das weitere Objekt auf, welches insbesondere eine Gehäuseeinheit und/oder eine Haushaltsgeräteplatte sein könnte. In wenigstens einem Betriebszustand ist die Lagereinheit insbesondere mechanisch mit dem weiteren Objekt verbunden und vorteilhaft von dem weiteren Objekt getragen. Erfindungsgemäß ist die Lagereinheit in wenigstens einem Betriebszustand innerhalb zumindest einer Gehäuseeinheit der Haushaltsgerätevorrichtung angeordnet. Die Haushaltsgerätevorrichtung weist insbesondere zumindest eine Haushaltsgeräteplatte und insbesondere zumindest eine Gehäuseeinheit auf, innerhalb welcher insbesondere die Lagereinheit wenigstens zu einem Großteil angeordnet ist und welche insbesondere mechanisch mit der Haushaltsgeräteplatte verbunden und insbesondere an der Haushaltsgeräteplatte befestigt ist.

Unter einer "Haushaltsgeräteplatte" soll insbesondere eine plattenartige Einheit verstanden werden, welche in wenigstens einem Betriebszustand zumindest einen Teil eines Haushaltsgerätegehäuses definiert und/oder ausbildet. Die Haushaltsgeräteplatte könnte beispielsweise eine Platte zumindest eines Kältegeräts, insbesondere eines Kältegerätekorpus und/oder einer Kältegerätetür, sein. Alternativ oder zusätzlich könnte die Haushaltsgeräteplatte insbesondere eine Platte zumindest eines Gargeräts sein, wie beispielsweise eine Backofentür und/oder Kochfeldplatte und/oder eine Induktionskochfeldplatte. Die Haushaltsgeräteplatte könnte alternativ oder zusätzlich beispielsweise eine Platte zumindest eines Reinigungsgeräts sein, wie beispielsweise einer Waschmaschine und/oder eines Trockners und/oder einer Spülmaschine.

Unter einer "Gehäuseeinheit" soll insbesondere eine Einheit verstanden werden, die dazu vorgesehen ist, in wenigstens einem Betriebszustand zumindest einen, insbesondere als Hohlraum ausgebildeten Aufnahmeraum zu einer Aufnahme und/oder zu einer Lagerung wenigstens eines Bauteils wenigstens teilweise zu begrenzen und/oder zu definieren. Das Bauteil könnte beispielsweise zumindest ein Heizelement und/oder eine Steuereinheit und/oder eine Versorgungseinheit und/oder eine Bedienerschnittstelle und/oder eine Kühlungseinheit und/oder eine Reinigungseinheit sein. Insbesondere begrenzen die Gehäuseeinheit und die Haushaltsgeräteplatte gemeinsam den Aufnahmeraum wenigstens im Wesentlichen. Der Aufnahmeraum ist insbesondere als ein Hohlraum ausgebildet. Die Gehäuseeinheit nimmt in wenigstens einem Betriebszustand insbesondere eine Gewichtskraft von Bauteilen wenigstens zu einem Großteil auf und/oder überträgt die Gewichtskraft an zumindest eine weitere Einheit, wie beispielsweise an die Haushaltsgeräteplatte.

Die Lagereinheit könnte beispielsweise mehrteilig ausgebildet sein und insbesondere zumindest zwei, vorteilhaft zumindest drei, besonders vorteilhaft zumindest vier und vorzugsweise mehrere Lagerteilelemente aufweisen. Die Lagerteilelemente könnten insbesondere mechanisch miteinander verbunden sein. Vorzugsweise ist die Lagereinheit einstückig ausgebildet. Unter "einstückig" soll insbesondere zumindest stoffschlüssig verbunden verstanden werden, beispielsweise durch einen Schweißprozess, einen Klebeprozess, einen Anspritzprozess und/oder einen anderen, dem Fachmann als sinnvoll erscheinenden Prozess, und/oder vorteilhaft in einem Stück geformt verstanden werden, wie beispielsweise durch eine Herstellung aus einem Guss und/oder durch eine Herstellung in einem Ein- oder Mehrkomponentenspritzverfahren und vorteilhaft aus einem einzelnen Rohling.

Beispielsweise könnte die Lagerreinheit wenigstens zu einem Großteil aus elektrisch isolierendem Material und/oder aus temperaturbeständigem Material ausgebildet sein. Vorteilhaft ist die Leiterplatte wenigstens zu einem Großteil aus Kunststoff ausgebildet. Die Leiterplatte und/oder die Lagerreinheit weist insbesondere eine Temperaturbeständigkeit von mindestens 40°C, insbesondere von mindestens 60°C, vorteilhaft von mindestens 80°C besonders vorteilhaft von mindestens 85°C, vorzugsweise von mindestens 90°C und besonders bevorzugt von mindestens 100°C auf.

In wenigstens einem Betriebszustand lagert die Lagereinheit die Empfangsleiterplatte, insbesondere bezüglich zumindest einer Richtung, in einem Abstand von mindestens 0,2 cm, insbesondere von mindestens 0,5 cm, vorteilhaft von mindestens 1 cm, besonders vorteilhaft von mindestens 2 cm, vorzugsweise von mindestens 3 cm und besonders bevorzugt von mindestens 5 cm beabstandet zu der Verarbeitungsleiterplatte. Unter einem "Abstand" soll hier und im Folgenden insbesondere eine kürzeste Distanz zwischen einer der Verarbeitungsleiterplatte zugewandten Begrenzungskante der Empfangsleiterplatte und einer der Empfangsleiterplatte zugewandten Begrenzungskante der Verarbeitungsleiterplatte verstanden werden. Der Abstand ist insbesondere wenigstens im Wesentlichen senkrecht und vorteilhaft senkrecht zu der der Verarbeitungsleiterplatte zugewandten Begrenzungskante der Empfangsleiterplatte und/oder zu der der Empfangsleiterplatte zugewandten Begrenzungskante der Verarbeitungsleiterplatte ausgerichtet. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Ebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist.

Unter einer "Haupterstreckungsebene" eines Objekts soll insbesondere eine Ebene verstanden werden, welche parallel zu einer größten Seitenfläche eines kleinsten gedachten geometrischen Quaders ist, welcher das Objekt gerade noch vollständig umschließt, und insbesondere durch den Mittelpunkt des Quaders verläuft. Insbesondere sind die Empfangsleiterplatte und die Verarbeitungsleiterplatte bei einer Betrachtung in einer senkrecht zu einer Haupterstreckungsebene der Verarbeitungsleiterplatte ausgerichteten Richtung frei von Schnittstellen und/oder frei von Überlappungen und vorteilhaft beabstandet zueinander angeordnet. Bei einer Betrachtung in einer senkrecht zu einer Haupterstreckungsebene der Verarbeitungsleiterplatte ausgerichteten Richtung bildet die Verarbeitungsleiterplatte insbesondere eine Fläche aus, welche insbesondere schnittfrei mit einer von der Empfangsleiterplatte ausgebildeten Fläche und insbesondere beabstandet zu einer von der Empfangsleiterplatte ausgebildeten Fläche angeordnet ist.

Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Ferner wird vorgeschlagen, dass die Haushaltsgerätevorrichtung zumindest eine Haushaltsgeräteplatte aufweist, auf deren dem Bediener abgewandten Seite die Funkempfangseinheit in wenigstens einem Betriebszustand angeordnet ist, wodurch insbesondere eine geschützte Anordnung der Funkempfangseinheit gewährleistet werden kann. In wenigstens einem Betriebszustand ist insbesondere die Haushaltsgeräteplatte zwischen der Funkempfangseinheit und dem Bediener angeordnet. Die Funkempfangseinheit ist in wenigstens einem Betriebszustand insbesondere von der Haushaltsgeräteplatte für einen Bediener verdeckt und/oder unzugänglich angeordnet.

Zudem wird vorgeschlagen, dass die Haushaltsgerätevorrichtung zumindest eine Gehäuseeinheit aufweist, an welcher die Funkempfangseinheit in dem Betriebszustand befestigt ist und welche an der Haushaltsgeräteplatte befestigt ist. In wenigstens einem Betriebszustand sind die Haushaltsgeräteplatte und die Gehäuseeinheit insbesondere mechanisch miteinander verbunden und vorteilhaft mechanisch aneinander befestigt. Die Haushaltsgeräteplatte und die Gehäuseeinheit bilden in wenigstens einem Betriebszustand insbesondere ein Haushaltsgerätegehäuse, insbesondere wenigstens zu einem Großteil und vorteilhaft vollständig, aus. Dadurch kann insbesondere eine langlebige Ausgestaltung erzielt werden, und zwar insbesondere aufgrund einer geschützten Anordnung der Funkempfangseinheit. Insbesondere kann ein ungestörter und/oder optimierter Funkempfang ermöglicht werden, da insbesondere störende Einflüsse und/oder eine Beschädigung der Funkempfangseinheit vermieden werden können.

Insbesondere könnte die Lagereinheit die Verarbeitungsleiterplatte und die Empfangsleiterplatte in wenigstens einem Betriebszustand in wenigstens einer parallel zu einer Haupterstreckungsebene der Haushaltsgeräteplatte ausgerichteten Richtung beabstandet zueinander lagern. Vorzugsweise lagert die Lagereinheit die Empfangsleiterplatte und die Verarbeitungsleiterplatte in dem Betriebszustand in unterschiedlichen insbesondere minimalen Abständen von der Haushaltsgeräteplatte. Insbesondere weist die Empfangsleiterplatte, insbesondere zumindest eine der Haushaltsgeräteplatte zugewandte Begrenzungskante der Empfangsleiterplatte, in wenigstens einem Betriebszustand einen Abstand von der Haushaltsgeräteplatte auf, welcher insbesondere verschieden ist von einem Abstand der Verarbeitungsleiterplatte, insbesondere zumindest einer der Haushaltsgeräteplatte zugewandten Begrenzungskante der Verarbeitungsleiterplatte, von der Haushaltsgeräteplatte. Beispielsweise könnte die Empfangsleiterplatte, insbesondere zumindest eine der Haushaltsgeräteplatte zugewandte Begrenzungskante der Empfangsleiterplatte, in wenigstens einem Betriebszustand einen Abstand von der Haushaltsgeräteplatte aufweisen, welcher insbesondere größer sein könnte als ein Abstand der Verarbeitungsleiterplatte, insbesondere als ein Abstand zumindest einer der Haushaltsgeräteplatte zugewandten Begrenzungskante der Verarbeitungsleiterplatte, von der Haushaltsgeräteplatte. Vorteilhaft weist die Empfangsleiterplatte, insbesondere zumindest eine der Haushaltsgeräteplatte zugewandte Begrenzungskante der Empfangsleiterplatte, in wenigstens einem Betriebszustand einen Abstand von der Haushaltsgeräteplatte auf, welcher insbesondere kleiner ist als ein Abstand der Verarbeitungsleiterplatte, insbesondere als ein Abstand zumindest einer der Haushaltsgeräteplatte zugewandten Begrenzungskante der Verarbeitungsleiterplatte, von der Haushaltsgeräteplatte. Dadurch können die Empfangsleiterplatte und die Verarbeitungsleiterplatte insbesondere flexibel relativ zueinander angeordnet werden, wodurch insbesondere die Verarbeitungsleiterplatte in einem kühlen und/oder geschützten Bereich, insbesondere innerhalb der Gehäuseeinheit, und die Empfangsleiterplatte insbesondere in einem Bereich, insbesondere der Gehäuseeinheit, angeordnet werden kann, in welchem optimaler Funkempfang möglich ist. Es können insbesondere akzeptable Temperaturen der Verarbeitungsleiterplatte und/oder der Empfangsleiterplatte ermöglicht werden, und zwar insbesondere durch Lagerung der Verarbeitungsleiterplatte und/oder der Empfangsleiterplatte in entsprechend geeigneten Temperaturbereichen, insbesondere innerhalb der Gehäuseeinheit. Es kann insbesondere ein optimierter Funkempfang gewährleistet werden.

Ferner wird vorgeschlagen, dass die Lagereinheit die Empfangsleiterplatte in dem Betriebszustand in einem Abstand von mindestens 1 mm, insbesondere von mindestens 2 mm, vorteilhaft von mindestens 5 mm, besonders vorteilhaft von mindestens 7 mm und vorzugsweise von mindestens 10 mm zu der Haushaltsgeräteplatte lagert. Dadurch kann die Empfangsleiterplatte insbesondere geschützt und/oder in einem Bereich geringer Temperatur angeordnet werden, wodurch insbesondere eine langlebige Ausgestaltung erzielt werden kann.

Zudem wird vorgeschlagen, dass die Lagereinheit die Empfangsleiterplatte in dem Betriebszustand in einem Abstand von maximal 25 mm, insbesondere von maximal 20 mm, vorteilhaft von maximal 25 mm, besonders vorteilhaft von maximal 10 mm und vorzugsweise von maximal 5 mm zu der Haushaltsgeräteplatte lagert. Dadurch kann insbesondere ein optimierter Funkempfang ermöglicht werden, wodurch das Funksignal insbesondere exakt detektiert werden kann.

Weiterhin wird vorgeschlagen, dass die Lagereinheit die Verarbeitungsleiterplatte in dem Betriebszustand in einem Abstand von mindestens 15 mm, insbesondere von mindestens 20 mm, vorteilhaft von mindestens 25 mm, besonders vorteilhaft von mindestens 30 mm und vorzugsweise von mindestens 35 mm zu der Haushaltsgeräteplatte lagert, wodurch die Verarbeitungsleiterplatte insbesondere besonders geschützt, insbesondere vor hohen Temperaturen, angeordnet und/oder gelagert werden kann, was insbesondere in einer langlebigen Ausgestaltung und/oder in einer zuverlässigen Funktionstüchtigkeit münden kann. Insbesondere lagert die Lagereinheit die Verarbeitungsleiterplatte in dem Betriebszustand in einem Abstand von maximal 70 mm, insbesondere von maximal 60 mm, vorteilhaft von maximal 55 mm, besonders vorteilhaft von maximal 50 mm und vorzugsweise von maximal 45 mm zu der Hausgeräteplatte.

Beispielsweise könnte die Lagereinheit die Empfangsleiterplatte und die Verarbeitungsleiterplatte in wenigstens einem Betriebszustand wenigstens im Wesentlichen und vorteilhaft vollständig parallel relativ zueinander lagern. Unter "im Wesentlichen parallel" soll hier insbesondere eine Ausrichtung einer Richtung relativ zu einer Bezugsrichtung, insbesondere in einer Ebene, verstanden werden, wobei die Richtung gegenüber der Bezugsrichtung eine Abweichung insbesondere kleiner als 8°, vorteilhaft kleiner als 5° und besonders vorteilhaft kleiner als 2° aufweist. Vorzugsweise lagert die Lagereinheit die Empfangsleiterplatte und die Verarbeitungsleiterplatte insbesondere in wenigstens einem Betriebszustand winklig relativ zueinander. Unter der Wendung, dass die Lagereinheit die Empfangsleiterplatte und die Verarbeitungsleiterplatte "winklig" relativ zueinander lagert, soll insbesondere verstanden werden, dass die Lagereinheit die Empfangsleiterplatte und die Verarbeitungsleiterplatte unter einem minimalen Winkel, welchen insbesondere eine Haupterstreckungsebene der Empfangsleiterplatte und eine Haupterstreckungsebene der Verarbeitungsleiterplatte miteinander einschließen, von mehr als, insbesondere ausschließlich, 0° bis zu, insbesondere einschließlich, 90° relativ zueinander lagert. Dadurch kann insbesondere eine hohe Flexibilität und/oder eine hohe Gestaltungsfreiheit hinsichtlich einer Anordnung der Empfangsleiterplatte und der Verarbeitungsleiterplatte relativ zueinander erreicht werden.

Die Lagereinheit könnte die Empfangsleiterplatte und die Verarbeitungsleiterplatte in wenigstens einem Betriebszustand insbesondere in einem minimalen Winkel von maximal 80°, insbesondere von maximal 70°, vorteilhaft von maximal 60° und vorzugsweise von maximal 50° relativ zueinander lagern. Alternativ oder zusätzlich könnte die Lagereinheit die Empfangsleiterplatte und die Verarbeitungsleiterplatte in wenigstens einem Betriebszustand insbesondere in einem minimalen Winkel von mindestens 5°, insbesondere von mindestens 10°, vorteilhaft von mindestens 15° und vorzugsweise von mindestens 20° relativ zueinander lagern. Vorzugsweise lagert die Lagereinheit die Empfangsleiterplatte und die Verarbeitungsleiterplatte wenigstens im Wesentlichen senkrecht relativ zueinander, wodurch insbesondere eine kompakte Ausgestaltung erzielt werden kann.

In wenigstens einem Betriebszustand könnte die Lagereinheit zumindest eine der Leiterplatten der Funkempfangseinheit, insbesondere die Empfangsleiterplatte und die Verarbeitungsleiterplatte, wenigstens im Wesentlichen horizontal und/oder wenigstens im Wesentlichen parallel der Haushaltsgeräteplatte, insbesondere zu einer Haupterstreckungsebene der Haushaltsgeräteplatte, lagern. Vorzugsweise lagert die Lagereinheit in wenigstens einem Betriebszustand zumindest eine der Leiterplatten der Funkempfangseinheit, insbesondere die Empfangsleiterplatte und die Verarbeitungsleiterplatte, wenigstens im Wesentlichen vertikal und/oder wenigstens im Wesentlichen senkrecht der Haushaltsgeräteplatte, insbesondere zu einer Haupterstreckungsebene der Haushaltsgeräteplatte. Dadurch kann insbesondere eine kompakte Ausgestaltung und/oder eine optimierte Ausnutzung von zur Verfügung stehendem Bauraum ermöglicht werden.

Ferner wird vorgeschlagen, dass die Lagereinheit die Empfangsleiterplatte wenigstens abschnittsweise innerhalb eines Heizelementbereichs lagert. Unter der Wendung, dass die Lagereinheit die Empfangsleiterplatte "wenigstens abschnittsweise" innerhalb eines Heizelementbereichs lagert, soll insbesondere verstanden werden, dass die Lagereinheit zumindest einen Abschnitt der Empfangsleiterplatte innerhalb des Heizelementbereichs lagert und insbesondere die gesamte Empfangsleiterplatte innerhalb des Heizelementbereichs lagern könnte. Unter einem "Abschnitt" der Empfangsleiterplatte soll in diesem Zusammenhang insbesondere ein Teilbereich der Empfangsleiterplatte verstanden werden. Insbesondere weist die Empfangsleiterplatte, vorteilhaft der Abschnitt der Empfangsleiterplatte, in wenigstens einem Betriebszustand einen Abstand zu der Haushaltsgeräteplatte auf, welcher maximal so groß und vorteilhaft kleiner ist wie ein Abstand der Verarbeitungsleiterplatte zu der Haushaltsgeräteplatte. Die Haushaltsgerätevorrichtung weist insbesondere zumindest zwei, vorteilhaft zumindest drei, besonders voreilhaft zumindest fünf und vorzugsweise eine Vielzahl an Heizelementen auf. Die Heizelemente sind in wenigstens einem Betriebszustand insbesondere wenigstens im Wesentlichen parallel zu der Haushaltsgeräteplatte ausgerichtet und spannen insbesondere wenigstens eine Ebene auf. Unter einem "Heizelementbereich" soll insbesondere ein räumlicher Bereich verstanden werden, innerhalb welchem in wenigstens einem Betriebszustand die Heizelemente angeordnet sind. Dadurch kann insbesondere ein Funksignal optimal empfangen werden, und zwar insbesondere in einem Vergleich zu einer Anordnung der Empfangsleiterplatte unterhalb des Heizelementbereichs, da insbesondere eine Abschirmung des Funksignals, beispielsweise durch die Heizelemente und/oder durch zumindest ein Abschirmelement, vermieden werden kann.

Ein optimierter Funkempfang kann insbesondere erreicht werden durch ein Haushaltsgerät, beispielsweise durch ein Gargerät, insbesondere durch ein Kochfeld und vorteilhaft durch ein Induktionskochfeld, mit zumindest einer Haushaltsgerätevorrichtung.

Die Haushaltsgerätevorrichtung soll hierbei nicht auf die oben beschriebene Anwendung und Ausführungsform beschränkt sein. Insbesondere kann die Haushaltsgerätevorrichtung zu einer Erfüllung einer hierin beschriebenen Funktionsweise eine von einer hierin genannten Anzahl von einzelnen Elementen, Bauteilen und Einheiten abweichende Anzahl aufweisen.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Haushaltsgerät mit einer Haushaltsgerätevorrichtung in einer schematischen Draufsicht,
- Fig. 2: eine Funkempfangseinheit, eine Lagereinheit und eine Kennzeichnungseinheit der Haushaltsgerätevorrichtung in einer Explosionsdarstellung,
- Fig. 3: die Funkempfangseinheit, die Lagereinheit und die Kennzeichnungseinheit in einem montierten Zustand in einer perspektivischen Darstellung,
- Fig. 4: eine Haushaltsgeräteplatte, eine Gehäuseeinheit, mehrere Heizelemente, eine Trägereinheit, eine Lagereinheit und eine Funkempfangseinheit der Haushaltsgerätevorrichtung in einer schematischen Darstellung,
- Fig. 5: eine Haushaltsgeräteplatte, eine Gehäuseeinheit, mehrere Heizelemente, eine Trägereinheit, eine Lagereinheit und eine Funkempfangseinheit einer alternativen Haushaltsgerätevorrichtung in einer stark vereinfachten schematischen Darstellung und
- Fig. 6: eine Haushaltsgeräteplatte, eine Gehäuseeinheit, mehrere Heizelemente, eine Trägereinheit, eine Lagereinheit und eine Funkempfangseinheit einer alternativen Haushaltsgerätevorrichtung in einer stark vereinfachten schematischen Darstellung.

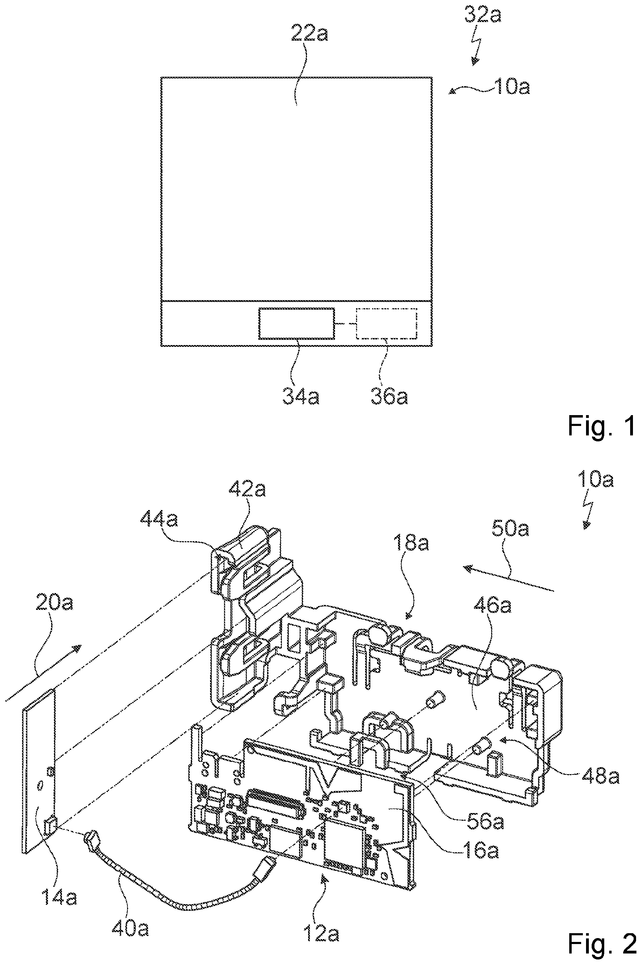

Fig. 1 zeigt ein Haushaltsgerät 32a mit einer Haushaltsgerätevorrichtung 10a. Das Haushaltsgerät 32a könnte beispielsweise als ein Kühlschrank und/oder als eine Waschmaschine ausgebildet sein. Im vorliegenden Ausführungsbeispiel ist das Haushaltsgerät 32a als ein Gargerät, insbesondere als ein Induktionsgargerät, ausgebildet. Beispielsweise könnte das Haushaltsgerät 32a als ein Backofen, insbesondere als ein Induktionsbackofen, und/oder als ein Herd, insbesondere als ein Induktionsherd, und/oder als ein Garofen, insbesondere als ein Induktionsgarofen, ausgebildet sein. Das Haushaltsgerät 32a ist als ein Kochfeld, insbesondere als ein Induktionskochfeld, ausgebildet. Die Haushaltsgerätevorrichtung 10a ist im vorliegenden Ausführungsbeispiel als eine Gargerätevorrichtung, insbesondere als eine Induktionsgargerätevorrichtung, ausgebildet. Die Haushaltsgerätevorrichtung 10a ist als eine Kochfeldvorrichtung, insbesondere als eine Induktionskochfeldvorrichtung, ausgebildet.

Die Haushaltsgerätevorrichtung 10a weist eine Haushaltsgeräteplatte 22a auf. In einem Betriebszustand bildet die Haushaltsgeräteplatte 22a einen Teil eines Geräteaußengehäuses, insbesondere des Haushaltsgeräts 32a, aus. Die Haushaltsgeräteplatte 22a bildet in einer Einbaulage einen einem Bediener zugewandten Teil des Geräteaußengehäuses aus. Die Haushaltsgeräteplatte 22a könnte beispielsweise als Frontplatte und/oder Deckplatte des Geräteaußengehäuses insbesondere eines als Backofen und/oder als Herd und/oder als Garofen und/oder als Kühlschrank und/oder als Waschmaschine ausgebildeten Haushaltsgeräts 32a ausgebildet sein. Im vorliegenden Ausführungsbeispiel ist die Haushaltsgeräteplatte 22a als eine Kochfeldplatte ausgebildet. In einem montierten Zustand ist die Haushaltsgeräteplatte 22a zu einem Aufstellen von Gargeschirr vorgesehen.

Die Haushaltsgerätevorrichtung 10a weist eine Bedienerschnittstelle 34a zu einer Eingabe und/oder Auswahl von Betriebsparametern (vgl. Fig. 1), beispielsweise einer Heizleistung und/oder einer Heizleistungsdichte und/oder einer Heizzone auf. Die Bedienerschnittstelle 34a ist zu einer Ausgabe eines Werts eines Betriebsparameters an einen Bediener vorgesehen. Beispielsweise könnte die Bedienerschnittstelle 34a den Wert des Betriebsparameters an einen Bediener optisch und/oder akustisch ausgeben.

Die Haushaltsgerätevorrichtung 10a weist eine Steuereinheit 36a auf. Die Steuereinheit 36a ist dazu vorgesehen, in Abhängigkeit von mittels der Bedienerschnittstelle 34a eingegebenen Betriebsparametern Aktionen auszuführen und/oder Einstellungen zu verändern.

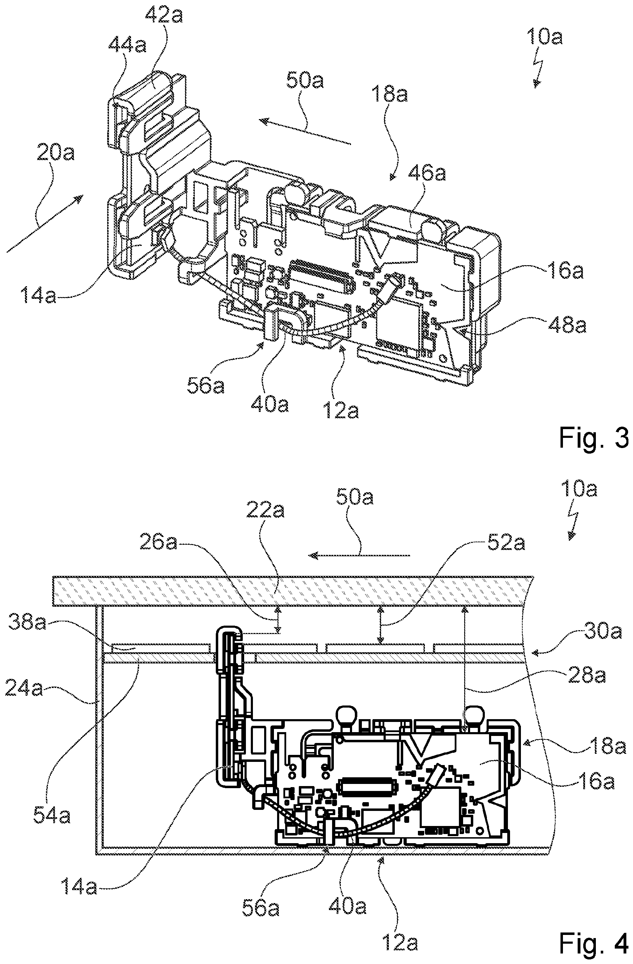

Die Haushaltsgerätevorrichtung 10a weist eine Vielzahl an Heizelementen 38a auf (vgl. Fig. 4). Von mehrfach vorhandenen Objekten ist in den Figuren jeweils lediglich eines mit einem Bezugszeichen versehen. In einem Betriebszustand sind die Heizelemente 38a auf einer einem Bediener abgewandten Seite der Haushaltsgeräteplatte 22a angeordnet. Die Heizelemente 38a definieren einen Heizelementbereich 30a. Die Heizelemente 38a, insbesondere eine der Haushaltsgeräteplatte 22a in einem Betriebszustand zugewandte Seite der Heizelemente 38a, definieren eine Ebene, welche im Wesentlichen parallel zu einer Haupterstreckungsebene der Haushaltsgeräteplatte 22a ausgerichtet ist.

Im vorliegenden Ausführungsbeispiel sind die Heizelemente 38a in Form einer Matrix angeordnet. Alternativ könnten die Heizelemente 38a wenigstens teilweise separate Heizzonen ausbilden und insbesondere in Form eines klassischen Kochfelds angeordnet sein.

Die Haushaltsgerätevorrichtung 10a weist eine Gehäuseeinheit 24a auf (vgl. Fig. 4). Die Gehäuseeinheit 24a bildet einen Teil des Geräteaußengehäuses aus. In einem Betriebszustand sind die Gehäuseeinheit 24a und die Haushaltsgeräteplatte 22a mechanisch miteinander verbunden. Die Gehäuseeinheit 24a ist in einem Betriebszustand an der Haushaltsgeräteplatte 22a befestigt.

In einem Betriebszustand trägt die Gehäuseeinheit 24a eine Funkempfangseinheit 12a. Die Haushaltsgerätevorrichtung 10a weist die Funkempfangseinheit 12a auf (vgl. Fig. 2 bis 4). Die Funkempfangseinheit 12a ist in einem Betriebszustand an der Gehäuseeinheit 24a befestigt. Die Funkempfangseinheit 12a ist in einem Betriebszustand zwischen einem Gehäuseboden der Gehäuseeinheit 24a und der Haushaltsgeräteplatte 22a angeordnet. In einem Betriebszustand ist die Funkempfangseinheit 12a auf einer dem Bediener abgewandten Seite der Haushaltsgeräteplatte 22a angeordnet.

Die Funkempfangseinheit 12a weist eine Empfangsleiterplatte 14a auf. Die Empfangsleiterplatte 14a ist zu einem Empfang eines Funksignals vorgesehen. In einem Betriebszustand empfängt die Empfangsleiterplatte 14a ein Funksignal, insbesondere von einer Funksendungseinheit (nicht dargestellt).

Die Funkempfangseinheit 12a weist eine Verarbeitungsleiterplatte 16a auf. Die Verarbeitungsleiterplatte 16a ist zu einer Verarbeitung des empfangenen Funksignals vorgesehen. Die Funkempfangseinheit 12a weist ein Kabel 40a auf. In einem Betriebszustand verbindet das Kabel 40a die Empfangsleiterplatte 14a und die Verarbeitungsleiterplatte 16a mechanisch und/oder elektrisch miteinander. Die Empfangsleiterplatte 14a und die Verarbeitungsleiterplatte 16a kommunizieren in einem Betriebszustand übe das Kabel 40a miteinander.

In einem Betriebszustand empfängt die Empfangsleiterplatte 14a ein Funksignal, insbesondere von einer Funksendungseinheit (nicht dargestellt). Die Empfangsleiterplatte 14a überträgt das empfangene Funksignal in einem Betriebszustand an die Verarbeitungsleiterplatte 16a. Im vorliegenden Ausführungsbeispiel bearbeitet die Verarbeitungsleiterplatte 16a in einem Betriebszustand das empfangene Funksignal. Die Verarbeitungsleiterplatte 16a wertet in einem Betriebszustand das empfangene Funksignal aus.

Die Haushaltsgerätevorrichtung 10a weist eine Lagereinheit 18a auf (vgl. Fig. 2 bis 4). In einem Betriebszustand lagert die Lagereinheit 18a die Funkempfangseinheit 12. Die Lagereinheit 18a lagert in einem Betriebszustand die Empfangsleiterplatte 14a beabstandet zu der Verarbeitungsleiterplatte 16a.

Die Lagereinheit 18a weist erfindungsgemäß ein erstes Lagerelement 42a auf. Das erste Lagerelement 42a definiert einen Aufnahmebereich 44a zu einer Lagerung der Empfangsleiterplatte 14a. In einem Betriebszustand lagert die Lagereinheit 18a mittels des ersten Lagerelements 42a die Empfangsleiterplatte 14a insbesondere in dem Aufnahmebereich 44a.

Die Lagereinheit 18a weist erfindungsgemäß ein zweites Lagerelement 46a auf. Das zweite Lagerelement 46a definiert einen Aufnahmebereich 48a zu einer Lagerung der Verarbeitungsleiterplatte 16a. In einem Betriebszustand lagert die Lagereinheit 18a mittels des zweiten Lagerelements 46a die Verarbeitungsleiterplatte 16a insbesondere in dem Aufnahmebereich 48a.

Das erste Lagerelement 42a und das zweite Lagerelement 46a sind einstückig miteinander verbunden. Die Lagereinheit 18a ist einstückig ausgebildet.

In einem Betriebszustand lagert die Lagereinheit 18a bei einer Betrachtung in einer senkrecht zu einer Haupterstreckungsebene der Verarbeitungsleiterplatte 16a ausgerichteten Richtung 20a die Empfangsleiterplatte 14a und die Verarbeitungsleiterplatte 16a überlappungsfrei. Die Lagereinheit 18a lagert bei einer Betrachtung in einer senkrecht zu einer Haupterstreckungsebene der Verarbeitungsleiterplatte 16a ausgerichteten Richtung 20a die Empfangsleiterplatte 14a und die Verarbeitungsleiterplatte 16a bezüglich einer parallel zu der Haupterstreckungsebene der Haushaltsgeräteplatte 22a ausgerichteten Querrichtung 50a nebeneinander. Die Querrichtung 50a ist parallel zu einer Haupterstreckungsebene der Haushaltsgeräteplatte 22a ausgerichtet.

Erfindungsgemäß lagert die Lagereinheit 18a die Empfangsleiterplatte 14a und die Verarbeitungsleiterplatte 16a in einem Betriebszustand in unterschiedlichen Abständen 26, 28, von der Haushaltsgeräteplatte 22a. Im vorliegenden Ausführungsbeispiel lagert die Lagereinheit 18a die Empfangsleiterplatte 14a in einem Betriebszustand in einem Abstand 26a von im Wesentlichen 4 mm zu der Haushaltsgeräteplatte 22a. Die Lagereinheit 18a lagert die Verarbeitungsleiterplatte 16a in einem Betriebszustand in einem Abstand 28a von im Wesentlichen 19 mm zu der Haushaltsgeräteplatte 22a.

In einem Betriebszustand lagert die Lagereinheit 18a die Empfangsleiterplatte 14a und die Verarbeitungsleiterplatte 16a winklig relativ zueinander. Im vorliegenden Ausführungsbeispiel lagert die Lagereinheit 18a die Empfangsleiterplatte 14a und die Verarbeitungsleiterplatte 16a in einem Betriebszustand im Wesentlichen senkrecht relativ zueinander.

Die Lagereinheit 18a lagert in einem Betriebszustand die Empfangsleiterplatte 14a im Wesentlichen senkrecht zu einer Haupterstreckungsebene der Haushaltsgeräteplatte 22a. In einem Betriebszustand lagert die Lagereinheit 18a die Empfangsleiterplatte 14a der Funkempfangseinheit 12a im Wesentlichen vertikal.

Die Lagereinheit 18a lagert in einem Betriebszustand die Verarbeitungsleiterplatte 16a im Wesentlichen senkrecht zu einer Haupterstreckungsebene der Haushaltsgeräteplatte 22a. In einem Betriebszustand lagert die Lagereinheit 18a die Verarbeitungsleiterplatte 16a der Funkempfangseinheit 12a im Wesentlichen vertikal. Die Lagereinheit 18a lagert in einem Betriebszustand die Leiterplatten 14a, 16a, der Funkempfangseinheit 12a im Wesentlichen vertikal.

Die Lagereinheit 18a weist eine Kabelführungseinheit 56a auf. Die Kabelführungseinheit 56a ist zu einer Führung des Kabels 40a vorgesehen. In einem Betriebszustand führt die Kabelführungseinheit 56a das Kabel 40a. Durch die Kabelführungseinheit 56a kann insbesondere eine hohe Sicherheit erzielt werden. Insbesondere kann eine schnelle Fehlererkennung und/oder eine einfache Reparatur ermöglicht werden, und zwar insbesondere aufgrund einer übersichtlichen Ausgestaltung.

In einem Betriebszustand lagert die Lagereinheit 18a die Empfangsleiterplatte 14a wenigstens abschnittsweise innerhalb des Heizelementbereichs 30a. Ein erster Abschnitt der Empfangsleiterplatte 14a ist in einem Betriebszustand innerhalb des Heizelementbereichs 30a angeordnet. Ein zweiter Abschnitt der Empfangsleiterplatte 14a ist in einem Betriebszustand oberhalb des Heizelementbereichs 30a angeordnet. Ein dritter Abschnitt der Empfangsleiterplatte 14a ist in einem Betriebszustand unterhalb des Heizelementbereichs 30a angeordnet.

Der Heizelementbereich 30a weist einen Abstand 52a von im Wesentlichen 6 mm zu der Haushaltsgeräteplatte 22a auf. Der Abstand 52a des Heizelementbereichs 30a zu der Haushaltsgeräteplatte 22a ist größer als der Abstand 26a der Empfangsleiterplatte 14a zu der Haushaltsgeräteplatte 22a. Der Abstand 52a des Heizelementbereichs 30a zu der Haushaltsgeräteplatte 22a ist kleiner als der Abstand 28a der Verarbeitungsleiterplatte 16a zu der Haushaltsgeräteplatte 22a.

Die Haushaltsgerätevorrichtung 10a weist eine Trägereinheit 54a auf. Die Trägereinheit 54a trägt in einem Betriebszustand die Heizelemente 38a. In einem Betriebszustand leitet die Trägereinheit 54a eine Gewichtskraft der Heizelemente 38a an die Gehäuseeinheit 24a weiter. Die Trägereinheit 54a ist in einem Betriebszustand an der Gehäuseeinheit 24a befestigt.

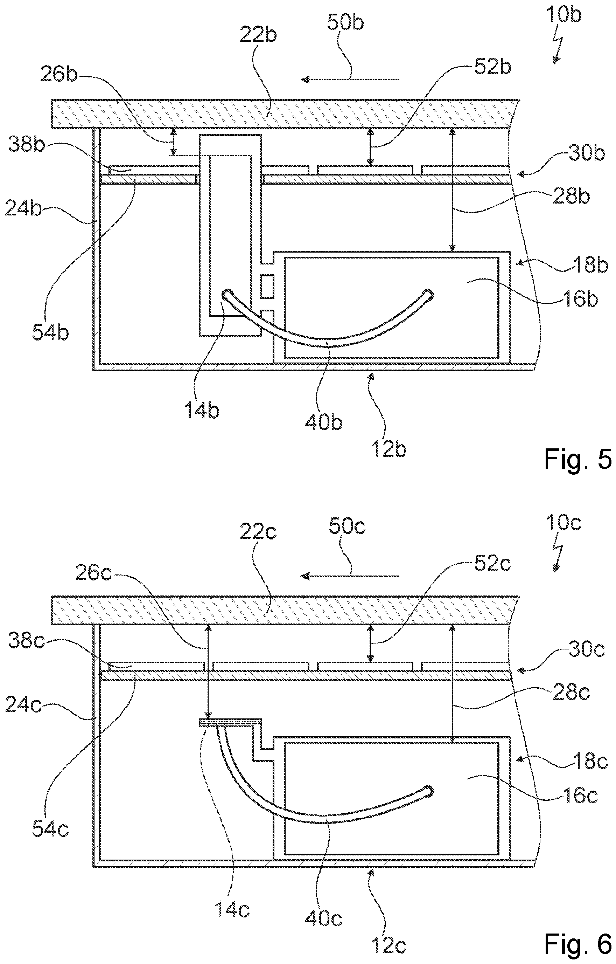

In Fig. 5 und 6 sind zwei weitere Ausführungsbeispiele der Erfindung gezeigt. Die nachfolgenden Beschreibungen beschränken sich im Wesentlichen auf die Unterschiede zwischen den Ausführungsbeispielen, wobei bezüglich gleich bleibender Bauteile, Merkmale und Funktionen auf die Beschreibung des Ausführungsbeispiels der Fig. 1 bis 4 verwiesen werden kann. Zur Unterscheidung der Ausführungsbeispiele ist der Buchstabe a in den Bezugszeichen des Ausführungsbeispiels in den Fig. 1 bis 4 durch die Buchstaben b und c in den Bezugszeichen des Ausführungsbeispiels der Fig. 5 und 6 ersetzt. Bezüglich gleich bezeichneter Bauteile, insbesondere in Bezug auf Bauteile mit gleichen Bezugszeichen, kann grundsätzlich auch auf die Zeichnungen und/oder die Beschreibung des Ausführungsbeispiels der Fig. 1 bis 4 verwiesen werden.

Fig. 5 zeigt eine alternative Haushaltsgerätevorrichtung 10b mit einer Funkempfangseinheit 12b, welche eine Empfangsleiterplatte 14b, die zu einem Empfang zumindest eines Funksignals vorgesehen ist, und eine Verarbeitungsleiterplatte 16b, die zu einer Verarbeitung des empfangenen Funksignals vorgesehen ist, aufweist. Die Haushaltsgerätevorrichtung 10b weist eine Lagereinheit 18b auf, welche die Empfangsleiterplatte 14b beabstandet zu der Verarbeitungsleiterplatte 16b lagert.

Im vorliegenden Ausführungsbeispiel lagert die Lagereinheit 18b die Empfangsleiterplatte 14b und die Verarbeitungsleiterplatte 16b parallel relativ zueinander. In einem Betriebszustand sind eine Haupterstreckungsebene der Empfangsleiterplatte 14b und eine Haupterstreckungsebene der Verarbeitungsleiterplatte 16b im Wesentlichen parallel zueinander ausgerichtet.

Fig. 6 zeigt eine alternative Haushaltsgerätevorrichtung 10c mit einer Funkempfangseinheit 12c, welche eine Empfangsleiterplatte 14c, die zu einem Empfang zumindest eines Funksignals vorgesehen ist, und eine Verarbeitungsleiterplatte 16c, die zu einer Verarbeitung des empfangenen Funksignals vorgesehen ist, aufweist. Die Haushaltsgerätevorrichtung 10c weist eine Lagereinheit 18c auf, welche die Empfangsleiterplatte 14c beabstandet zu der Verarbeitungsleiterplatte 16c lagert.

Im vorliegenden Ausführungsbeispiel lagert die Lagereinheit 18c die Empfangsleiterplatte 14c und die Verarbeitungsleiterplatte 16c winklig, und zwar insbesondere im Wesentlichen senkrecht, relativ zueinander. In einem Betriebszustand lagert die Lagereinheit 18c die Verarbeitungsleiterplatte 16c der Funkempfangseinheit 12c im Wesentlichen vertikal. Die Lagereinheit 18c lagert in einem Betriebszustand die Empfangsleiterplatte 14c der Funkempfangseinheit 12c im Wesentlichen horizontal. Die Lagereinheit 18c lagert die Empfangsleiterplatte 14c in einem Betriebszustand unterhalb eines Heizelementbereichs 30c.

### Bezugszeichen

- 10: Haushaltsgerätevorrichtung
- 12: Funkempfangseinheit
- 14: Empfangsleiterplatte
- 16: Verarbeitungsleiterplatte
- 18: Lagereinheit
- 20: Richtung
- 22: Haushaltsgeräteplatte
- 24: Gehäuseeinheit
- 26: Abstand
- 28: Abstand
- 30: Heizelementbereich
- 32: Haushaltsgerät
- 34: Bedienerschnittstelle
- 36: Steuereinheit
- 38: Heizelement
- 40: Kabel
- 42: Erstes Lagerelement
- 44: Aufnahmebereich
- 46: Zweites Lagerelement
- 48: Aufnahmebereich
- 50: Querrichtung
- 52: Abstand
- 54: Trägereinheit
- 56: Kabelführungseinheit

## Patentansprüche

1. Kochfeld mit zumindest einer Haushaltsgerätevorrichtung (10a-c) mit zumindest einer Funkempfangseinheit (12a-c), welche zumindest eine Empfangsleiterplatte (14a-c), die zu einem Empfang zumindest eines Funksignals vorgesehen ist, und zumindest eine Verarbeitungsleiterplatte (16a-c), die zu einer Verarbeitung des empfangenen Funksignals vorgesehen ist, aufweist, und mit zumindest einer Lagereinheit (18a-c), welche die Empfangsleiterplatte (14a-c) beabstandet zu der Verarbeitungsleiterplatte (16a-c) lagert, wobei die Lagereinheit (18a-c) bei einer Betrachtung in einer senkrecht zu einer Haupterstreckungsebene der Verarbeitungsleiterplatte (16a-c) ausgerichteten Richtung (20a-c) die Empfangsleiterplatte (14a-c) und die Verarbeitungsleiterplatte (16a-c) überlappungsfrei lagert, wobei die Haushaltsgerätevorrichtung (10a-c) zumindest eine Haushaltsgeräteplatte (22a-c) aufweist, auf deren dem Bediener abgewandten Seite die Funkempfangseinheit (12a-c) in wenigstens einem Betriebszustand angeordnet ist, **dadurch gekennzeichnet, dass** die Lagereinheit (18a-c) die Empfangsleiterplatte (14a-c) und die Verarbeitungsleiterplatte (16a-c) in dem Betriebszustand in unterschiedlichen Abständen (26a-c, 28a-c) von der Haushaltsgeräteplatte (22a-c) lagert, und die Lagereinheit (18a-c) in wenigstens einem Betriebszustand innerhalb zumindest einer Gehäuseeinheit (24a-c) der Haushaltsgerätevorrichtung (10a-c) angeordnet ist, wobei die zumindest eine Lagereinheit (18a) ein erstes Lagerelement (42a) aufweist, welches einen Aufnahmebereich (44a) zu einer Lagerung der Empfangsleiterplatte (14a) definiert, wobei die Lagereinheit (18a) ein zweites Lagerelement (46a) aufweist, welches einen Aufnahmebereich (48a) zu einer Lagerung der Verarbeitungsleiterplatte (16a) definiert, wobei die zumindest eine Lagereinheit (18a) in einem Betriebszustand mittels des ersten Lagerelements (42a) die Empfangsleiterplatte (14a) und mittels des zweiten Lagerelements (46a) die Verarbeitungsleiterplatte (16a) lagert.

2. Kochfeld nach Anspruch 1, **dadurch gekennzeichnet, dass** die Haushaltsgerätevorrichtung (10a-c) zumindest eine Gehäuseeinheit (24a-c) aufweist, an welcher die Funkempfangseinheit (12a-c) in dem Betriebszustand befestigt ist und welche an der Haushaltsgeräteplatte (22a-c) befestigt ist.

3. Kochfeld nach einem der vorhergehenden Ansprüche, **dadurch gekennzeichnet, dass** die Lagereinheit (18a-c) die Empfangsleiterplatte (14a-c) in dem Betriebszustand in einem Abstand (26a-c) von mindestens 1 mm zu der Haushaltsgeräteplatte (22a-c) lagert.

4. Kochfeld nach einem der vorhergehenden Ansprüche, **dadurch gekennzeichnet, dass** die Lagereinheit (18a-c) die Empfangsleiterplatte (14a-c) in dem Betriebszustand in einem Abstand (26a-c) von maximal 25 mm zu der Haushaltsgeräteplatte (22a-c) lagert.

5. Kochfeld nach einem der vorhergehenden Ansprüche, **dadurch gekennzeichnet, dass** die Lagereinheit (18a-c) die Verarbeitungsleiterplatte (16a-c) in dem Betriebszustand in einem Abstand (28a-c) von mindestens 15 mm zu der Haushaltsgeräteplatte (22a-c) lagert.

6. Kochfeld nach einem der vorhergehenden Ansprüche, **dadurch gekennzeichnet, dass** die Lagereinheit (18a, 18c) die Empfangsleiterplatte (14a; 14c) und die Verarbeitungsleiterplatte (16a, 16c) winklig relativ zueinander lagert.

7. Kochfeld nach Anspruch 6, **dadurch gekennzeichnet, dass** die Lagereinheit (18a-c) die Empfangsleiterplatte (14a; 14c) und die Verarbeitungsleiterplatte (16a, 16c) wenigstens im Wesentlichen senkrecht relativ zueinander lagert.

8. Kochfeld nach einem der vorhergehenden Ansprüche, **dadurch gekennzeichnet, dass** die Lagereinheit (18a-c) in wenigstens einem Betriebszustand zumindest eine der Leiterplatten (14a-c, 16a-c) der Funkempfangseinheit (12a-c) wenigstens im Wesentlichen vertikal lagert.

9. Kochfeld nach einem der vorhergehenden Ansprüche, **dadurch gekennzeichnet, dass** die Lagereinheit (18a-b) die Empfangsleiterplatte (14a-b) wenigstens abschnittsweise innerhalb eines Heizelementbereichs (30a-b) lagert.

## Claims

1. Hob with at least one household appliance apparatus (10a-c) with at least one radio receiving unit (12a-c), which has at least one receiving circuit board (14a-c), which is provided for receiving at least one radio signal, and at least one processing circuit board (16a-c), which is provided for processing the received radio signal, and with at least one mounting unit (18a-c), which mounts the receiving circuit board (14a-c) at a distance from the processing circuit board (16a-c), wherein the mounting unit (18a-c) mounts the receiving circuit board (14a-c) and the processing circuit board (16a-c) without overlap when viewed in a direction (20a-c) oriented perpendicularly to a main extension plane of the processing circuit board (16a-c), wherein the household appliance apparatus (10a-c) has at least one household appliance board (22a-c), on the side of which facing the operator the radio receiving unit (12a-c) is arranged in at least one operating state, **characterised in that** the mounting unit (18a-c) mounts the receiving circuit board (14a-c) and the processing circuit board (16a-c) at different distances (26a-c, 28a-c) from the household appliance board (22a-c) in the operating state, and the mounting unit (18a-c) is arranged within at least one housing unit (24a-c) of the household appliance apparatus (10a-c) in at least one operating state, wherein the at least one mounting unit (18a) has a first mounting element (42a), which defines an accommodating region (44a) for mounting the receiving circuit board (14a), wherein the mounting unit (18a) has a second mounting element (46a), which defines an accommodating region (48a) for mounting the processing circuit board (16a), wherein the at least one mounting unit (18a), in an operating state, mounts the receiving circuit board (14a) by means of the first mounting element (42a) and mounts the processing circuit board (16a) by means of the second mounting element (46a).

2. Hob according to claim 1, **characterised in that** the household appliance apparatus (10a-c) has at least one housing unit (24a-c), to which the radio receiving unit (12a-c) is fastened in the operating state and which is fastened to the household appliance board (22a-c).

3. Hob according to one of the preceding claims, **characterised in that** the mounting unit (18a-c) mounts the receiving circuit board (14a-c) at a distance (26a-c) of at least 1 mm from the household appliance board (22a-c) in the operating state.

4. Hob according to one of the preceding claims, **characterised in that** the mounting unit (18a-c) mounts the receiving circuit board (14a-c) at a distance (26a-c) of at most 25 mm from the household appliance board (22a-c) in the operating state.

5. Hob according to one of the preceding claims, **characterised in that** the mounting unit (18a-c) mounts the processing circuit board (16a-c) at a distance (28a-c) of at least 15 mm from the household appliance board (22a-c) in the operating state.

6. Hob according to one of the preceding claims, **characterised in that** the mounting unit (18a, 18c) mounts the receiving circuit board (14a; 14c) and the processing circuit board (16a, 16c) at an angle relative to one another.

7. Hob according to claim 6, **characterised in that** the mounting unit (18a-c) mounts the receiving circuit board (14a; 14c) and the processing circuit board (16a, 16c) in a perpendicular manner relative to one another.

8. Hob according to one of the preceding claims, **characterised in that** the mounting unit (18a-c) mounts at least one of the circuit boards (14a-c, 16a-c) of the radio receiving unit (12a-c) in an at least substantially vertical manner in at least one operating state.

9. Hob according to one of the preceding claims, **characterised in that** the mounting unit (18a-b) mounts the receiving circuit board (14a-b) within a heating element region (30a-b), at least in sections.

## Revendications

1. Plaque de cuisson avec au moins un dispositif d'appareil électroménager (10a-c) avec au moins une unité de réception radio (12a-c), qui présente au moins une carte de circuit imprimé de réception (14a-c), qui est prévue pour une réception d'au moins un signal radio, et au moins une carte de circuit imprimé de traitement (16a-c), qui est prévue pour traiter le signal radio reçu, et avec au moins une unité de stockage (18a-c), qui stocke la carte de circuit imprimé de réception (14a-c) à distance de la carte de circuit de traitement (16a-c), dans laquelle l'unité de stockage (18a-c), lorsqu'elle est considérée dans une direction orientée perpendiculairement (20a-c) à un plan d'extension principal de la carte de circuit imprimé de traitement (16a-c), stocke la carte de circuit imprimé de réception (14a-c) et la carte de circuit imprimé de traitement (16a-c) sans chevauchement, dans laquelle le dispositif d'appareil électroménager (10a-c) présente au moins une carte d'appareil électroménager (22a-c), sur laquelle est disposée l'unité de réception radio (12a-c) sur le côté opposé à l'utilisateur dans au moins un état de fonctionnement, **caractérisée en ce que** l'unité de stockage (18a-c) stocke la carte de circuit imprimé de réception (14a-c) et la carte de circuit imprimé de traitement (16a-c) à différentes distances (26a-c, 28a-c) de la carte d'appareil électroménager (22a-c) dans l'état de fonctionnement, et l'unité de stockage (18a-c), dans au moins un état de fonctionnement, est disposée à l'intérieur d'au moins une unité de boîtier (24a-c) du dispositif d'appareil électroménager (10a-c), dans laquelle ladite au moins une unité de stockage (18a) présente un premier élément de stockage (42a) définissant une zone de réception (44a) pour un stockage de la carte de circuit imprimé de réception (14a), dans laquelle l'unité de stockage (18a) présente un second élément de stockage (46a) qui définit une zone de réception (48a) pour un stockage de la carte de circuit imprimé de traitement (16a), dans laquelle ladite au moins une unité de stockage (18a), dans un état de fonctionnement, stocke la carte de circuit imprimé de réception (14a) au moyen du premier élément de stockage (42a) et la carte de circuit imprimé de traitement (16a) au moyen du second élément de stockage (46a).

2. Plaque de cuisson selon la revendication 1, **caractérisée en ce que** le dispositif d'appareil électroménager (10a-c) présente au moins une unité de boîtier (24a-c) à laquelle est fixée l'unité de réception radio (12a-c) dans l'état de fonctionnement et qui est fixée à la carte d'appareil électroménager (22a-c).

3. Plaque de cuisson selon l'une des revendications précédentes, **caractérisée en ce que** l'unité de stockage (18a-c) stocke la carte de circuit imprimé de réception (14a-c) dans l'état de fonctionnement à une distance (26a-c) d'au moins 1 mm de la carte d'appareil électroménager (22a-c).

4. Plaque de cuisson selon l'une des revendications précédentes, **caractérisée en ce que** l'unité de stockage (18a-c) stocke la carte de circuit imprimé de réception (14a-c) dans l'état de fonctionnement à une distance (26a-c) de maximum 25 mm de la carte d'appareil électroménager (22a-c).

5. Plaque de cuisson selon l'une des revendications précédentes, **caractérisée en ce que** l'unité de stockage (18a-c) stocke la carte de circuit imprimé de traitement (16a-c) dans l'état de fonctionnement à une distance (28a-c) d'au moins 15 mm de la carte d'appareil électroménager (22a-c).

6. Plaque de cuisson selon l'une des revendications précédentes, **caractérisée en ce que** l'unité de stockage (18a ; 18c) stocke la carte de circuit imprimé de réception (14a ; 14c) et la carte de circuit imprimé de traitement (16a ; 16c) avec un angle l'une par rapport à l'autre.

7. Plaque de cuisson selon la revendication 6, **caractérisée en ce que** l'unité de stockage (18a-c) stocke la carte de circuit imprimé de réception (14a ; 14c) et la carte de circuit imprimé de traitement (16a ; 16c) au moins essentiellement verticalement l'une par rapport à l'autre.

8. Plaque de cuisson selon l'une des revendications précédentes, **caractérisée en ce que** l'unité de stockage (18a-c), dans au moins un état de fonctionnement, stocke au moins l'une des cartes de circuit imprimé (14a-c, 16a-c) de l'unité de réception radio (12a-c) au moins essentiellement verticalement.

9. Plaque de cuisson selon l'une des revendications précédentes, **caractérisée en ce que** l'unité de stockage (18a-b) stocke la carte de circuit imprimé de réception (14a-b) au moins par segments à l'intérieur d'une zone d'élément chauffant (30a-b).
